# EUROPEAN PATENT SPECIFICATION

(11) **EP 3 379 901 B1**
(45) Date of publication and mention of the grant of the patent: **30.12.2020**
(21) Application number: 18162711.8
(22) Date of filing: 20.03.2018
(51) Int. Cl.: H05B 45/58

(54) **LED FAILURE DETECTING DEVICE**
LED-FEHLERDETEKTORVORRICHTUNG
DISPOSITIF DE DÉTECTION DE DÉFAILLANCE DE DEL

(30) Priority: 21.03.2017 TW 106109313
(43) Date of publication of application: 26.09.2018
(73) Proprietor: Macroblock, Inc., Hsinchu 30072 (TW)
(72) Inventor: HUANG, Ping-Kai, Hsinchu 30072 (TW); TSAI, Chung-Ta, Hsinchu 30072 (TW)
(74) Representative: Regimbeau

(56) References cited:
- CN-A- 106 033 661
- DE-A1-102011 106 670
- DE-A1-102014 112 176
- GB-A- 2 449 949
- US-A1- 2010 053 040
- US-A1- 2012 176 039

## Description

The disclosure relates to failure detection, and more particularly to a light emitting diode (LED) failure detecting device.

Light emitting diodes (LEDs) are widely used today in lighting and display applications. It is important to provide a device (such as that disclosed in U.S. Patent Application Publication No. 2014/0097849) for detecting LED failures in these applications, thereby informing relevant personnel of possible occurrences of LED failures in order to have failed LEDs or LED strings replaced in a timely fashion.

Document US2010053040 A1 describes a display device having horizontal and vertical scanning lines. A detect information storing section stores defect information when any optical element has a defect.

Document GB2449949 describes a driving apparatus for reporting states of a LED channels in a binary mode comprises a plurality of channel points (NCHm), at least one controller, a plurality of detectors, and a signal converter. The controller controls operation of the connected LED channels and the signal converter receives a detecting signal generated by each detector and corresponding to the state of the LED channel, and computes the received detecting signal to generate a report signal with N bits in a binary mode, wherein N is an integer greater than 1, and the number of the channel points is less than 2<N>. The number of channels is preferably greater than or equal to 2<N-1>.; The detector may comprise voltage comparators comparing the channel voltage with voltage references corresponding to error states such as an open circuit and a short circuit, and logic element such as gate to aggregate the state into detecting signal.

Therefore, an object of the disclosure is to provide a light emitting diode (LED) failure detecting device according to claim 1 that can detect a failure of an LED unit or LED.

According to an aspect of the disclosure, the LED failure detecting device is operatively associated with an LED array. The LED array includes a plurality of scan lines, a plurality of data lines, and a plurality of LED units that are arranged in a matrix with a plurality of rows and a plurality of columns. Each of the LED units has a first terminal and a second terminal, and permits current flow therethrough from the first terminal thereof to the second terminal thereof. For each of the rows of the LED units, the first terminals of the LED units are coupled to a respective one of the scan lines.
For each of the columns of the LED units, the second terminals of the LED units are coupled to a respective one of the data lines. The LED failure detecting device includes a driving circuit and a determining circuit. The driving circuit is used to be coupled to the scan lines and the data lines, receives a first control input that corresponds to selection of one of the LED units, and drives the LED units based on the first control input in such a way that a current flows through said one of the LED units. The determining circuit is used to be coupled to the data lines for receiving a plurality of voltages respectively thereat, and further receives a second control input that at least corresponds to selection of one of the data lines which is coupled to said one of the LED units. The determining circuit generates, based at least on the voltages at the data lines and the second control input, a determination output that indicates whether said one of the LED units is determined to have failed.

According to another aspect of the disclosure, the LED failure detecting device is operatively associated with an LED unit. The LED unit has a first terminal and a second terminal, and permits current flow therethrough from the first terminal thereof to the second terminal thereof. The LED failure detecting device includes a driving circuit and a determining circuit. The driving circuit is used to be coupled to the second terminal of the LED unit, receives a control input, and drives the LED unit based on the control input in such a way that a current flows through the LED unit. The determining circuit includes a subtractor and a comparing module. The subtractor is used to be coupled to the second terminal of the LED unit for receiving a first voltage thereat, is used to further receive a second voltage, and obtains a difference between the first and second voltages to generate a difference voltage. The comparing module is coupled to the subtractor for receiving the difference voltage therefrom, is used to further receive a predetermined first threshold voltage and a predetermined second threshold voltage, and compares the difference voltage with the predetermined first and second threshold voltages to generate a determination output that indicates whether the LED unit is determined to have failed.

According to yet another aspect of the disclosure, the LED failure detecting device is operatively associated with an LED unit. The LED unit includes a first terminal, a second terminal, and a plurality of LEDs that are coupled in series between the first and second terminals of the LED unit. The LED unit permits current flow from the first terminal thereof through the LEDs thereof to the second terminal thereof. The LED failure detecting device includes a driving circuit and a determining circuit. The driving circuit is used to be coupled to the second terminal of the LED unit, receives a control input, and drives the LED unit based on the control input in such a way that a current flows through the LED unit. The determining circuit is used to be coupled to the LEDs, generates a plurality of difference voltages that respectively correspond to respective voltages across the LEDs, and generates, based on the difference voltages, a determination output that indicates whether each of the LEDs is determined to have failed.

Other features and advantages of the disclosure will become apparent in the following detailed description of the embodiments with reference to the accompanying drawings, of which:
Fig. 1 is a circuit block diagram illustrating a first embodiment of a light emitting diode (LED) failure detecting device according to the disclosure;
Fig. 2 is a block diagram illustrating a first implementation of a determining circuit of the first embodiment;
Fig. 3 is a circuit diagram illustrating a comparing module of the first implementation of the determining circuit of the first embodiment;
Fig. 4 is a block diagram illustrating a second implementation of the determining circuit of the first embodiment;
Fig. 5 is a circuit block diagram illustrating a second embodiment of the LED failure detecting device according to the disclosure;
Fig. 6 is a block diagram illustrating a determining circuit of the second embodiment;
Fig. 7 is a circuit block diagram illustrating a third embodiment of the LED failure detecting device according to the disclosure;
Fig. 8 is a circuit block diagram illustrating a fourth embodiment of the LED failure detecting device according to the disclosure; and
Fig. 9 is a circuit block diagram illustrating a fifth embodiment of the LED failure detecting device according to the disclosure.

Before the disclosure is described in greater detail, it should be noted that where considered appropriate, reference numerals or terminal portions of reference numerals have been repeated among the figures to indicate corresponding or analogous elements, which may optionally have similar characteristics.

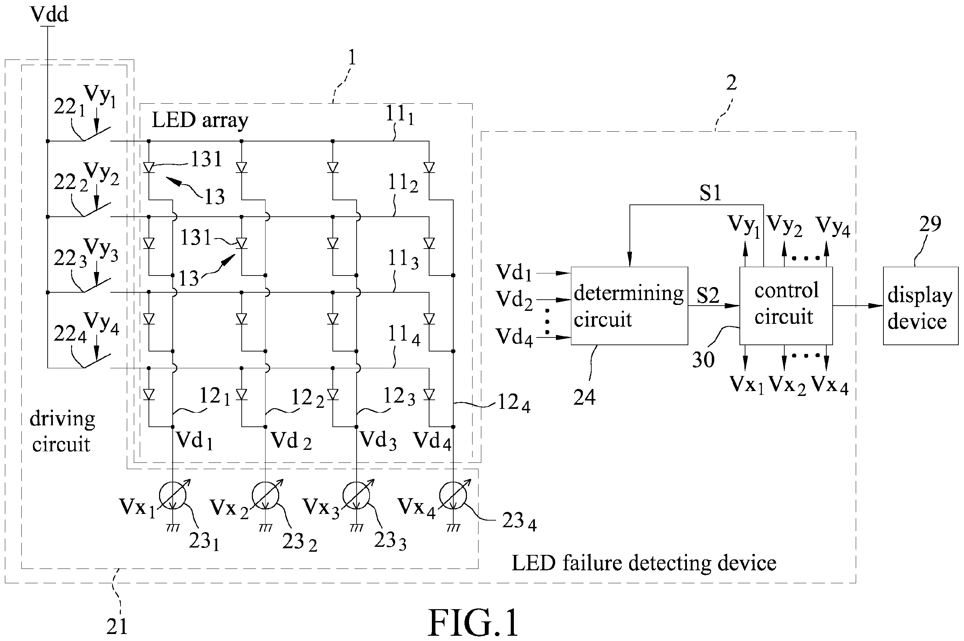

Referring to Fig. 1, a first embodiment of a light emitting diode (LED) failure detecting device 2 according to the disclosure is operatively associated with an LED array 1 and a display device 29. The LED array 1 includes a number (M) of scan lines (11₁-11_{M}), a number (N) of data lines (12₁-12_{N}), and a number (M×N) of LED units 13 that are arranged in a matrix with a number (M) of rows and a number (N) of columns, where M≥2 and N≥2. For illustration purposes, M=4 and N=4 in this embodiment. Each LED unit 13 includes a first terminal, a second terminal, and a number (P) of LEDs 131 coupled between the first and second terminals thereof, where P≥1. When P≥2, the LEDs 131 of each LED unit 13 are coupled in series to form an LED string. For illustration purposes, P=1 in this embodiment. Each LED unit 13 permits current flow from the first terminal thereof through the LED 131 thereof to the second terminal thereof. For each row of the LED units 13, the first terminals of the LED units 13 of the row are coupled to a respective scan line 11₁-11₄. For each column of the LED units 13, the second terminals of the LED units 13 of the column are coupled to a respective data line 12₁-12₄.

The LED failure detecting device 2 of this embodiment includes a driving circuit 21, a determining circuit 24 and a control circuit 30.

The driving circuit 21 is used to be coupled to the scan lines 11₁-11₄ and the data lines 12₁-12₄, and receives a first control input that corresponds to selection of one of the LED units 13 (e.g., the LED unit 13 that is coupled to an m^{th} one of the scan lines (11ₘ) and an n^{th} one of the data lines (12ₙ), where 1≤m≤M (1≤m≤4 in this embodiment) and 1≤n≤N ( 1≤n≤4 in this embodiment)). The driving circuit 21 drives the LED units 13 based on the first control input in such a way that a current flows through said one of the LED units 13 (hereinafter referred to as the target LED unit 13 for simplicity), and that no current flows through each remaining one of the LED units 13.

The determining circuit 24 is used to be coupled to the data lines 12₁-12₄ for receiving a number (N) (four in this embodiment) of first voltages (Vd₁-Vd₄) respectively thereat, and further receives a second control input (S1) that corresponds to selection of the data line (12ₙ) which is coupled to the target LED unit 13. The determining circuit 24 generates, based on the first voltages (Vd₁-Vd₄) and the second control input (S1), a determination output (S2) that indicates whether the target LED unit 13 is determined to have failed.

The control circuit 30 is coupled to the driving circuit 21 and the determining circuit 24, and is used to be coupled further to the display device 29. The control circuit 30 controls the driving circuit 21 and the determining circuit 24 in such a way that the LED units 13 take turns to serve as the target LED unit, and that the determination output (S2) indicates the respective states (having failed or not having failed) of the LED units 13 one by one. For each LED unit 13, the control circuit 30 performs the following: (a) generating, for receipt by the driving circuit 21, the first control input that corresponds to the selection of the LED unit 13 as the target LED unit; (b) generating, for receipt by the determining circuit 24, the second control input (S1) that corresponds to the selection of the data line (12ₙ) which is coupled to the target LED unit 13; (c) receiving the determination output (S2) from the determining circuit 24; and (d) generating, for receipt by the display device 29, a detection output based on the selection of the target LED unit 13 and on the determination output (S2) in such a way that the display device 29 can display the position of the target LED unit 13 in the LED array 1 and the state (having failed or not having failed) of the target LED unit 13.

In this embodiment, the first control input includes a number (M) (four in this embodiment) of switching control signals (Vy₁-Vy₄) and a number (N) (four in this embodiment) of current control signals (Vx₁-Vx₄), and the driving circuit 21 includes a number (M) (four in this embodiment) of switches 22₁-22₄ and a number (N) (four in this embodiment) of current sources 23₁-23₄. Each switch 22₁-22₄ has a first terminal that is used to receive a supply voltage (Vdd), a second terminal that is used to be coupled to a respective scan line 11₁-11₄, and a control terminal that is coupled to the control circuit 30 for receiving a respective switching control signal (Vy₁-Vy₄) therefrom. Each current source 23₁-23₄ is coupled to the control circuit 30 for receiving a respective current control signal (Vx₁-Vx₄) therefrom, generates a respective driving current signal based on the respective current control signal (Vx₁-Vx₄), and is used to be coupled further to a respective data line 12₁-12₄ for providing the respective driving current signal thereto. For the LED unit 13 that is coupled to the scan line 11ᵢ and the data line 12ⱼ, a current flows through the LED unit 13 when the switch 22ᵢ conducts while the driving current signal generated by the current source 23ⱼ is non-zero, and no current flows through the LED unit 13 otherwise, where 1≤i≤M (1≤i≤4 in this embodiment) and 1≤j≤N (1≤j≤4 in this embodiment).

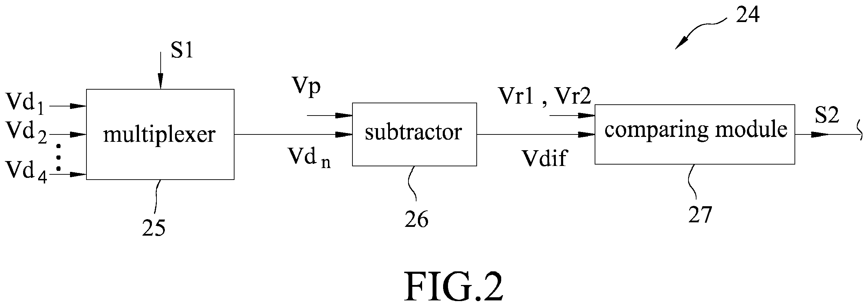

Fig. 2 illustrates a first implementation of the determining circuit 24. Referring to Figs. 1 and 2, in the first implementation, the determining circuit 24 includes a multiplexer 25, a subtractor 26 and a comparing module 27 as shown in Fig. 2. The multiplexer 25 is used to be coupled to the data lines 12₁-12₄ for receiving the first voltages (Vd₁-Vd₄) respectively thereat, is coupled further to the control circuit 30 for receiving the second control input (S1) therefrom, and outputs, based on the second control input (S1), the first voltage (Vdₙ) at the data line (12ₙ) that is coupled to the target LED unit 13. The subtractor 26 is coupled to the multiplexer 25 for receiving the first voltage (Vdₙ) outputted thereby, is used to further receive a predetermined second voltage (Vp), and obtains a difference between the first and second voltages (Vdₙ, Vp) to generate a difference voltage (Vdif) (e.g., Vdif=Vp-Vdₙ) that is correlated to a voltage across the target LED unit 13. The comparing module 27 is coupled to the subtractor 26 for receiving the difference voltage (Vdif) therefrom, is used to further receive a predetermined first threshold voltage (Vr1) and a predetermined second threshold voltage (Vr2), and is coupled further to the control circuit 30. The comparing module 27 compares the difference voltage (Vdif) with the predetermined first and second threshold voltages (Vr1, Vr2) to generate the determination output (S2) for receipt by the control circuit 30. For all subsequent examples, the predetermined first threshold voltage (Vr1) is lower than the predetermined second threshold voltage (Vr2).

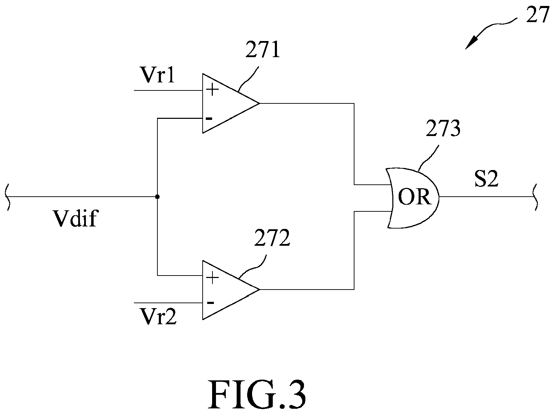

Referring to Fig. 3, the comparing module 27 includes a first comparator 271, a second comparator 272 and an OR gate 273. The first comparator 271 has a non-inverting input terminal that is used to receive the predetermined first threshold voltage (Vr1), an inverting input terminal that is coupled to the subtractor 26 for receiving the difference voltage (Vdif) therefrom, and an output terminal. The second comparator 272 has a non-inverting input terminal that is coupled to the subtractor 26 for receiving the difference voltage (Vdif) therefrom, an inverting input terminal that is used to receive the predetermined second threshold voltage (Vr2), and an output terminal. The OR gate 273 has a first input terminal that is coupled to the output terminal of the first comparator 271, a second input terminal that is coupled to the output terminal of the second comparator 272, and an output terminal that is coupled to the control circuit 30 and that provides the determination output (S2). When the difference voltage (Vdif) is within a threshold voltage range, ranging from the predetermined first threshold voltage (Vr1) to the predetermined second threshold voltage (Vr2), the determination output (S2) is at a logic low level to indicate that the target LED unit 13 is determined not to have failed. When the difference voltage (Vdif) is not within the threshold voltage range, such as being lower than the predetermined first threshold voltage (Vr1) (e.g., due to a short circuit failure of the target LED unit 13) or higher than the predetermined second threshold voltage (Vr2) (e.g., due to an open circuit failure of the target LED unit 13), the determination output (S2) is at a logic high level to indicate that the target LED unit 13 is determined to have failed.

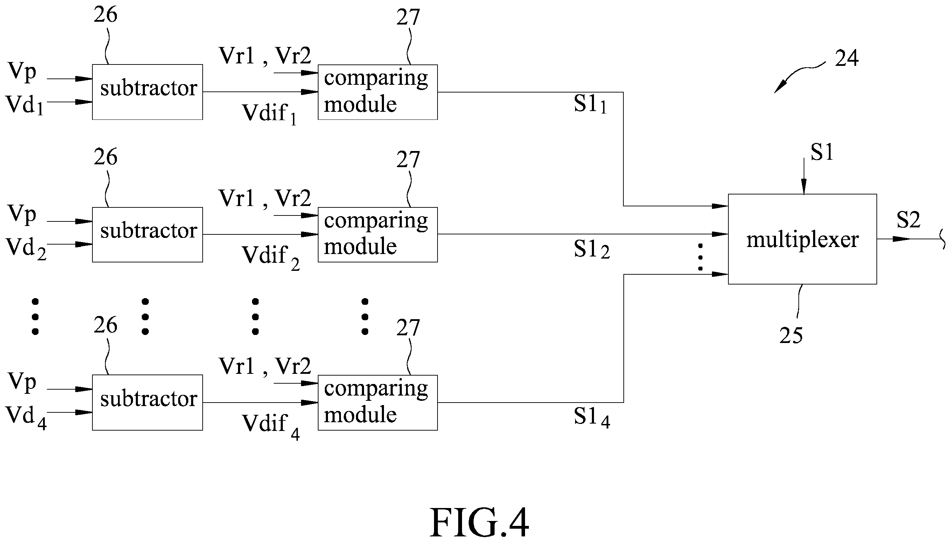

Fig. 4 illustrates a second implementation of the determining circuit 24. Referring to Figs. 1 and 4, in the second implementation, the determining circuit 24 includes a number (N) (four in this embodiment) of subtractors 26, a number (N) (four in this embodiment) of comparing modules 27 and a multiplexer 25 as shown in Fig. 4. Each of the subtractors 26 is used to be coupled to a respective data line 12₁-12₄ for receiving the first voltage (Vd₁-Vd₄) thereat, is used to further receive a predetermined second voltage (Vp), and obtains a difference between the first and second voltages (Vd₁-Vd₄, Vp) to generate a respective difference voltage (Vdifⱼ) (e.g., Vdifⱼ=Vp-Vdⱼ, where 1≤j≤N). Each comparing module 27 is coupled to a respective subtractor 26 for receiving the respective difference voltage (Vdifⱼ) therefrom, is used to further receive a predetermined first threshold voltage (Vr1) and a predetermined second threshold voltage (Vr2), and compares the respective difference voltage (Vdifⱼ) with the predetermined first and second threshold voltages (Vr1, Vr2) to generate a respective determination signal (S1₁-S1₄). In an example, where each comparing module 27 has a configuration as shown in Fig. 3, when the difference voltage (Vdifₙ) (which is related to the first voltage (Vdₙ) at the data line (12ₙ) that is coupled to the target LED unit 13) is within the threshold voltage range, the determination signal (S1ₙ) (which is related to the first voltage (Vdₙ) at the data line (12ₙ) that is coupled to the target LED unit 13) is at the logic low level, and when the difference voltage (Vdifₙ) is not within the threshold voltage range, the determination signal (S1ₙ) is at the logic high level. The multiplexer 25 is coupled to the comparing modules 27 for receiving the determination signals (S1₁-S1₄) respectively therefrom, is coupled further to the control circuit 30 for receiving the second control input (S1) therefrom, and outputs, based on the second control input (S1), the determination signal (S1ₙ) to serve as the determination output (S2) for receipt by the control circuit 30.

In view of the above, for the first embodiment, by virtue of the determining circuit 24 that generates the determination output (S2) which indicates whether the target LED unit 13 is determined to have failed, relevant personnel can be informed of possible occurrences of LED failures in order to have the failed LED units 13 replaced in a timely fashion.

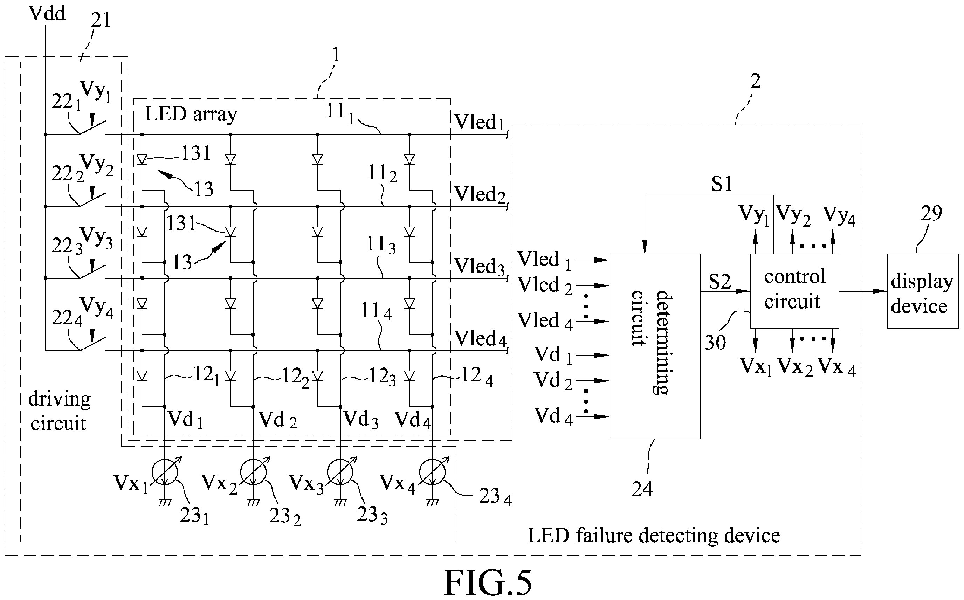

Referring to Fig. 5, a second embodiment of the LED failure detecting device 2 according to the disclosure is a modification of the first embodiment, and differs from the first embodiment in that: (a) the second control input (S1) further corresponds to selection of the scan line (11ₘ) which is coupled to the target LED unit 13; and (b) the determining circuit 24 is used to be coupled further to the scan lines 11₁-11₄ for receiving a number (M) (four in the second embodiment) of second voltages (Vled₁-Vled₄) respectively thereat, and generates the determination output (S2) based further on the second voltages (Vled₁-Vled₄).

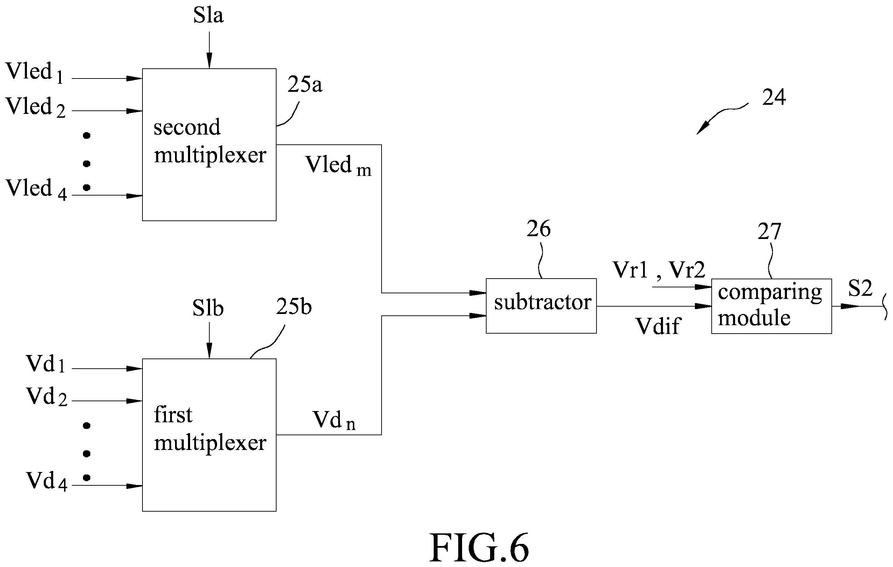

Referring to Figs. 5 and 6, in the second embodiment, the second control input (S1) includes a first control signal (S1b) that corresponds to the selection of the data line (12ₙ) which is coupled to the target LED unit 13, and a second control signal (S1a) that corresponds to the selection of the scan line (11ₘ) which is coupled to the target LED unit 13; and the determining circuit 24 includes a first multiplexer (25b), a second multiplexer (25a), a subtractor 26 and a comparing module 27. The first multiplexer (25b) is used to be coupled to the data lines (12₁-12₄) for receiving the first voltages (Vd₁-Vd₄) respectively thereat, is coupled further to the control circuit 30 for receiving the first control signal (S1b) therefrom, and outputs, based on the first control signal (S1b), the first voltage (Vdₙ) at the data line (12ₙ) that is coupled to the target LED unit 13. The second multiplexer (25a) is used to be coupled to the scan lines 11₁-11₄ for receiving the second voltages (Vled₁-Vled₄) respectively thereat, is coupled further to the control circuit 30 for receiving the second control signal (S1a) therefrom, and outputs, based on the second control signal (S1a), the second voltage (Vledₘ) at the scan line (11ₘ) that is coupled to the target LED unit 13. The subtractor 26 is coupled to the first and second multiplexers (25b, 25a) for receiving the first and second voltages (Vdₙ, Vledₘ) respectively outputted thereby, and obtains a difference between the first and second voltages (Vdₙ, Vledₘ) to generate a difference voltage (Vdif) (e.g., Vdif=Vledₘ-Vdₙ) that is correlated to a voltage across the target LED unit 13. The comparing module 27 is coupled to the subtractor 26 for receiving the difference voltage (Vdif) therefrom, is used to further receive a predetermined first threshold voltage (Vr1) and a predetermined second threshold voltage (Vr2), and is coupled further to the control circuit 30. The comparing module 27 compares the difference voltage (Vdif) with the predetermined first and second threshold voltages (Vr1, Vr2) to generate the determination output (S2) for receipt by the control circuit 30. In an example, where the comparing module 27 has a configuration as shown in Fig. 3, when the difference voltage (Vdif) is within the threshold voltage range, the determination output (S2) is at the logic low level, and when the difference voltage (Vdif) is not within the threshold voltage range, the determination output (S2) is at the logic high level.

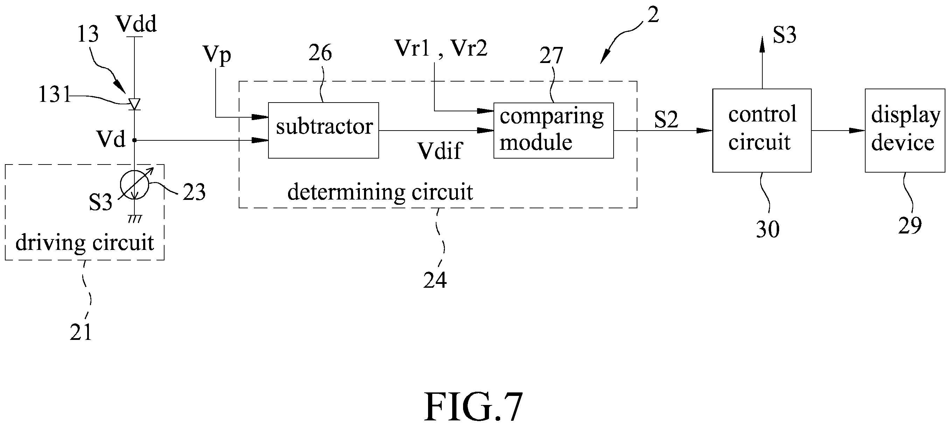

Referring to Fig. 7, a third embodiment of the LED failure detecting device 2 according to the disclosure is operatively associated with an LED unit 13 and a display device 29. The LED unit 13 includes a first terminal that receives a supply voltage (Vdd), a second terminal, and a number (P) of LEDs 131 that are coupled between the first and second terminals thereof, where P≥1. When P≥2, the LEDs 131 are coupled in series to form an LED string. For illustration purposes, P=1 in this embodiment. The LED unit 13 permits current flow from the first terminal thereof through the LED 131 thereof to the second terminal thereof.

The LED failure detecting device 2 of this embodiment includes a driving circuit 21, a determining circuit 24 and a control circuit 30.

The driving circuit 21 is used to be coupled to the second terminal of the LED unit 13, receives a control input (S3), and drives the LED unit 13 based on the control input (S3) in such a way that a current flows through the LED unit 13.

In this embodiment, the driving circuit 21 includes a current source 23. The current source 23 receives the control input (S3), generates a driving current signal based on the control input (S3), and is used to be coupled to the second terminal of the LED unit 13 for providing the driving current signal thereto. A current flows through the LED unit 13 when the driving current signal is non-zero, and no current flows through the LED unit 13 otherwise.

The determining circuit 24 is used to be coupled to the second terminal of the LED unit 13 for receiving a first voltage (Vd) thereat, and generates, based on the first voltage (Vd), a determination output (S2) that indicates whether the LED unit 13 is determined to have failed.

In this embodiment, the determining circuit 24 includes a subtractor 26 and a comparing module 27. The subtractor 26 is used to be coupled to the second terminal of the LED unit 13 for receiving the first voltage (Vd) thereat, is used to further receive a predetermined second voltage (Vp), and obtains a difference between the first and second voltages (Vd, Vp) to generate a difference voltage (Vdif) (e.g., Vdif=Vp-Vd) that is correlated to a voltage across the LED unit 13. The comparing module 27 is coupled to the subtractor 26 for receiving the difference voltage (Vdif) therefrom, is used to further receive a predetermined first threshold voltage (Vr1) and a predetermined second threshold voltage (Vr2), and compares the difference voltage (Vdif) with the predetermined first and second threshold voltages (Vr1, Vr2) to generate the determination output (S2). Like all previous examples, the comparing module 27 in this example has a configuration as shown in Fig. 3. As a consequence, when the difference voltage (Vdif) is within the threshold voltage range, the determination output (S2) is at the logic low level, and when the difference voltage (Vdif) is not within the threshold voltage range, the determination output (S2) is at the logic high level.

The control circuit 30 is coupled to the current source 23 and the comparing module 27, and is used to be coupled further to the display device 29. The control circuit 30 generates the control input (S3) for receipt by the current source 23, receives the determination output (S2) from the comparing module 27, and generates, for receipt by the display device 29, a detection output based on the determination output (S2) in such a way that the display device 29 can display the state (having failed or not having failed) of the LED unit 13.

In view of the above, for the third embodiment, by virtue of the determining circuit 24 that generates the determination output (S2) which indicates whether the LED unit 13 is determined to have failed, relevant personnel can be informed of possible occurrence of an LED failure in order to have the failed LED unit 13 replaced in a timely fashion.

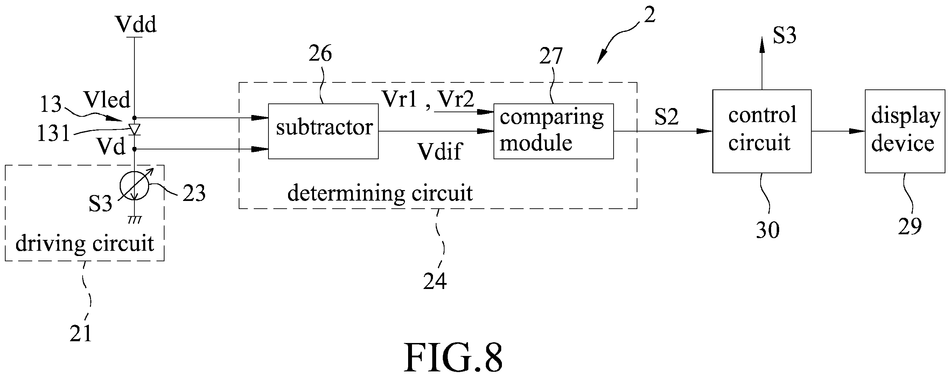

Referring to Fig. 8, a fourth embodiment of the LED failure detecting device 2 according to the disclosure is a modification of the third embodiment, and differs from the third embodiment in that: (a) the second voltage (Vled) is a voltage at the first terminal of the LED unit 13, instead of being predetermined; and (b) the subtractor 26 is used to be coupled further to the first terminal of the LED unit 13 for receiving the second voltage (Vled) thereat.

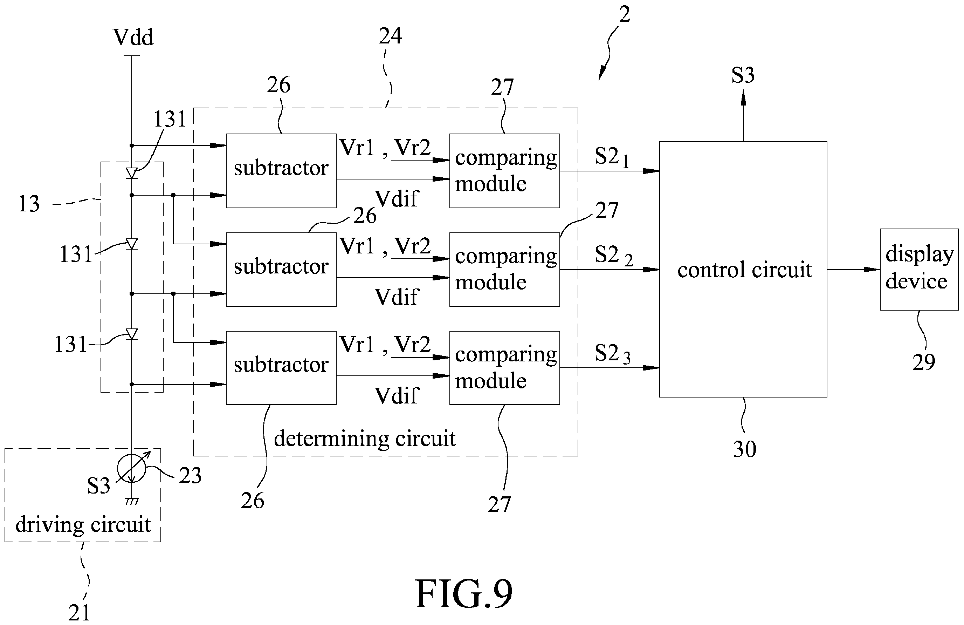

Referring to Fig. 9, a fifth embodiment of the LED failure detecting device 2 according to the disclosure is operatively associated with an LED unit 13 and a display device 29. The LED unit 13 includes a first terminal that receives a supply voltage (Vdd), a second terminal, and a number (P) of LEDs 131 that are coupled is series between the first and second terminals of the LED unit 13, where P≥2. For illustration purposes, P=3 in this embodiment. Each LED 131 has an anode and a cathode . The LED unit 13 permits current flow from the first terminal thereof through the LEDs 131 thereof to the second terminal thereof.

The LED failure detecting device 2 of this embodiment includes a driving circuit 21, a determining circuit 24 and a control circuit 30.

The driving circuit 21 is used to be coupled to the second terminal of the LED unit 13, receives a control input (S3), and drives the LED unit 13 based on the control input (S3) in such a way that a current flows through the LED unit 13.

In this embodiment, the driving circuit 21 includes a current source 23. The current source 23 receives the control input (S3), generates a driving current signal based on the control input (S3), and is used to be coupled to the second terminal of the LED unit 13 for providing the driving current signal thereto. A current flows through the LED unit 13 when the driving current signal is non-zero, and no current flows through the LED unit 13 otherwise.

The determining circuit 24 is used to be coupled to the LEDs 131, generates a number (P) (three in this embodiment) of difference voltages (Vdif) that respectively correspond to respective voltages across the LEDs 131, and generates, based on the difference voltages (Vdif), a determination output that indicates whether each LED 131 is determined to have failed.

In this embodiment, the determining circuit 24 includes a number (P) (three in this embodiment) of subtractors 26 and a number (P) (three in this embodiment) of comparing module 27. Each subtractor 26 is used to be coupled to the anode and the cathode of a respective LED 131 for receiving two terminal voltages respectively thereat, and obtains a difference between the terminal voltages to generate a respective one of the difference voltages (Vdif). Each comparing module 27 is coupled to a respective subtractor 26 for receiving the respective difference voltage (Vdif) therefrom, is used to further receive a predetermined first threshold voltage (Vr1) and a predetermined second threshold voltage (Vr2), and compares the respective difference voltage (Vdif) with the predetermined first and second threshold voltages (Vr1, Vr2) to generate a respective determination signal (S2₁-S2₃). The determination output includes the determination signals (S2₁-S2₃). As with the previous examples, each comparing module 27 has a configuration as shown in Fig. 3. As a result, for each difference voltage (Vdif), when the difference voltage (Vdif) is within the voltage threshold range, the respective determination signal (S2₁-S2₃) is at the logic low level, and when the difference voltage (Vdif) is not within the voltage threshold range, the respective determination signal (S2₁-S2₃) is at the logic high level.

The control circuit 30 is coupled to the current source 23 and the comparing modules 27, and is used to be coupled further to the display device 29. The control circuit 30 generates the control input (S3) for receipt by the current source 23, receives the determination signals (S2₁-S2₃) respectively from the comparing modules 27, and generates, for receipt by the display device 29, a detection output based on the determination signals (S2₁-S2₃) in such a way that the display device 29 can display the state (having failed or not having failed) of each LED 131.

In view of the above, for the fifth embodiment, by virtue of the determining circuit 24 that generates the determination output which indicates whether each LED 131 is determined to have failed, relevant personnel can be informed of possible occurrences of LED failures in order to have the failed LEDs 131 replaced in a timely fashion.

In the description above, for the purposes of explanation, numerous specific details have been set forth in order to provide a thorough understanding of the embodiments. It will be apparent, however, to one skilled in the art, that one or more other embodiments may be practiced without some of these specific details.

## Claims

1. A light emitting diode, LED, failure detecting device (2) operatively associated with an LED array (1), the LED array (1) including a plurality of scan lines (11₁-11₄), a plurality of data lines (12₁-12₄), and a plurality of LED units (13) that are arranged in a matrix with a plurality of rows and a plurality of columns, each of the LED units (13) having a first terminal and a second terminal, and permitting current flow therethrough from the first terminal thereof to the second terminal thereof; for each of the rows of the LED units, the first terminals of the LED units (13) being coupled to a respective one of the scan lines (11₁-11₄); for each of the columns of the LED units, the second terminals of the LED units (13) being coupled to a respective one of the data lines (12₁-12₄); said LED failure detecting device (2) comprising:
a driving circuit (21) in use coupled to the scan lines (11₁-11₄) and the data lines (12₁-12₄), adapted to receive a first control input that corresponds to selection of one of the LED units (13), and adapted to drive the LED units (13) based on the first control input in such a way that a current flows through said one of the LED units (13); and **characterised by**
a determining circuit (24) in use coupled to the data lines (12₁-12₄) for receiving a plurality of first voltages (Vd₁-Vd₄) respectively thereat, and further adapted to receive a second control input (S1) that at least corresponds to selection of one of the data lines (12ₙ) which is coupled to said one of the LED units (13), said determining circuit (24) adapted to generate, based at least on the first voltages (Vd₁-Vd₄) and the second control input (S1), a determination output (S2) that indicates whether said one of the LED units (13) is determined to have failed; and
a control circuit (30) coupled to said driving circuit (21) and said determining circuit (24); for said one of the LED units (13), said control circuit (30) adapted to generate the first control input for receipt by said driving circuit (21), adapted to generate the second control input (S1) for receipt by said determining circuit (24), adapted to receive the determination output (S2) from said determining circuit (24), and adapted to generate a detection output based on the selection of said one of the LED units (13) and on the determination output (S2);
said determining circuit (24) including
a multiplexer (25) in use coupled to the data lines (12₁-12₄) for receiving the first voltages (Vd₁-Vd₄) respectively thereat, further adapted to receive the second control input (S1), and adapted to output, based on the second control input (S1), one of the first voltages (Vdₙ) at said one of the data lines (12ₙ) that is coupled to said one of the LED units (13),
a subtractor (26) coupled to said multiplexer (25) for receiving said one of the first voltages (Vdₙ) outputted thereby, in use further receiving a predetermined second voltage (Vp), and adapted to obtain a difference between said one of the first voltages (Vdₙ) and the second voltage (Vp) to generate a difference voltage (Vdif), and
a comparing module (27) coupled to said subtractor (26) for receiving the difference voltage (Vdif) therefrom, in use further receiving a predetermined first threshold voltage (Vr1) and a predetermined second threshold voltage (Vr2), and adapted to compare the difference voltage (Vdif) with the predetermined first and second threshold voltages (Vr1, Vr2) to generate the determination output (S2);
the predetermined first threshold voltage (Vr1) being lower than the predetermined second threshold voltage (Vr2);
said comparing module (27) including
a first comparator (271) having a non-inverting input terminal that in use receives the predetermined first threshold voltage (Vr1), an inverting input terminal that is coupled to said subtractor (26) for receiving the difference voltage (Vdif) therefrom, and an output terminal;
a second comparator (272) having a non-inverting input terminal that is coupled to said subtractor (26) for receiving the difference voltage (Vdif) therefrom, an inverting input terminal that in use receives the predetermined second threshold voltage (Vr2), and an output terminal; and
an OR gate (273) having a first input terminal that is coupled to said output terminal of said first comparator (271), a second input terminal that is coupled to said output terminal of said second comparator (272), and an output terminal that is adapted to provide the determination output (S2).

2. The LED failure detecting device (2) of claim 1, **characterized in that** the first control input includes a plurality of switching control signals (Vy₁-Vy₄) and a plurality of current control signals (Vx₁-Vx₄), and said driving circuit (21) includes:
a plurality of switches (22₁-22₄) each having a first terminal that in use receives a supply voltage (Vdd), a second terminal that in use is coupled to a respective one of the scan lines (11₁-11₄), and a control terminal that receives a respective one of the switching control signals (Vy₁-Vy₄); and
a plurality of current sources (23₁-23₄), each of which is adapted to receive a respective one of the current control signals (Vx₁-Vx₄), each of which is adapted to generate a respective driving current signal based on the respective one of the current control signals (Vx₁-Vx₄), and each of which in use is coupled to a respective one of the data lines (12₁-12₄) for providing the driving current signal thereto.

## Patentansprüche

1. Fehlererkennungsvorrichtung für lichtemittierende Dioden, LED, (2), welche operativ mit einer LED-Anordnung (1) verknüpft ist, wobei die LED-Anordnung (1) eine Vielzahl von Abtastlinien (11₁-11₄), eine Vielzahl von Datenlinien (12₁-12₄) und eine Vielzahl von LED-Einheiten (13), welche in einer Matrix mit einer Vielzahl von Zeilen und einer Vielzahl von Spalten angeordnet sind, beinhaltet, wobei jede LED-Einheiten (13) einen ersten Anschluss und einen zweiten Anschluss aufweist, und Stromfluss dadurch von dem ersten Anschluss davon zu dem zweiten Anschluss davon erlaubt; wobei für jede der Zeilen der LED-Einheiten die ersten Anschlüsse der LED-Einheiten (13) mit einer entsprechenden der Abtastlinien (11₁-11₄) gekoppelt ist; wobei für jede der Spalten der LED-Einheiten die zweiten Anschlüsse der LED-Einheiten (13) mit einer entsprechenden der Datenlinien (12₁-12₄) gekoppelt ist; wobei die LED-Fehlererkennungsvorrichtung (2) umfasst:
eine Treiberschaltung (21), welche in Verwendung mit den Abtastlinien (11₁-11₄) und den Datenlinien (12₁-12₄) gekoppelt ist, welche adaptiert ist, um eine erste Steuereingabe zu empfangen, welche einer Auswahl einer der LED-Einheiten (13) entspricht; und adaptiert ist, um die LED-Einheiten (13) auf Basis der ersten Steuereingabe auf eine solche Weise anzusteuern, dass ein Strom durch die eine der LED-Einheiten (13) fließt;
und **gekennzeichnet ist durch** eine Bestimmungsschaltung (24), welche in Verwendung mit den Datenlinien (12₁-12₄) gekoppelt ist, zum Empfangen einer Vielzahl von ersten Spannungen (Vd₁-Vd₄) jeweils daselbst, und weiter adaptiert ist, um eine zweite Steuereingabe (S1) zu empfangen, welche zumindest einer Auswahl von einer der Datenlinien (12ₙ) entspricht, welche mit der einen der LED-Einheiten (13) gekoppelt ist, wobei die Bestimmungsschaltung (24) adaptiert ist, um auf Basis zumindest der ersten Spannungen (Vd₁-Vd₄) und der zweiten Steuereingabe (S1) eine Bestimmungsausgabe (S2) zu erzeugen, welche angibt, ob die eine der LED-Einheiten (13) als fehlerhaft bestimmt ist; und
eine Steuerschaltung (30), welche mit der Treiberschaltung (21) und der Bestimmungsschaltung (24) gekoppelt ist; wobei für die eine der LED-Einheiten (13) die Steuerschaltung (30) adaptiert ist, um die erste Steuereingabe für Empfang durch die Treiberschaltung (21) zu erzeugen, adaptiert ist, um die zweite Steuereingabe (S1) für Empfang durch die Bestimmungsschaltung (24) zu erzeugen, adaptiert ist, um die Bestimmungsausgabe (S2) von der Bestimmungsschaltung (24) zu empfangen, und adaptiert ist, um eine Erfassungsausgabe auf Basis der Auswahl der einen der LED-Einheiten (13) und der Bestimmungsausgabe (S2) zu erzeugen;
wobei die Bestimmungsschaltung (24) beinhaltet:
einen Multiplexer (25), welcher in Verwendung mit den Datenlinien (12₁-12₄) gekoppelt ist, zum Empfangen der ersten Spannungen (Vd₁-Vd₄) jeweils daselbst, weiter adaptiert ist, um die zweite Steuereingabe (S1) zu empfangen, und adaptiert ist, um auf Basis der zweiten Steuereingabe (S1) eine der ersten Spannungen (Vdₙ) an der einen der Datenlinien (12ₙ), welche mit der einen der LED-Einheiten (13) gekoppelt ist, auszugeben,
einen Subtrahierer (26), welcher mit dem Multiplexer (25) gekoppelt ist, zum Empfangen der einen der dadurch ausgegebenen ersten Spannungen (Vdₙ), welcher in Verwendung weiter eine vorbestimmte zweite Spannung (Vp) empfängt, und adaptiert ist, um eine Differenz zwischen der einen der ersten Spannungen (Vdₙ) und der zweiten Spannung (Vp) zu erhalten, um eine Differenzspannung (Vdif) zu erzeugen, und
ein Vergleichsmodul (27), welches an den Subtrahierer (26) gekoppelt ist, um die Differenzspannung (Vdif) davon zu empfangen, welches in Verwendung weiter eine vorbestimmte erste Schwellenspannung (Vr1) und eine vorbestimmte zweite Schwellenspannung (Vr2) empfängt, und adaptiert ist, um die Differenzspannung (Vdif) mit der vorbestimmten ersten und zweiten Schwellenspannung (Vr1, Vr2) zu vergleichen, um die Bestimmungsausgabe (S2) zu erzeugen;
wobei die vorbestimmte erste Schwellenspannung (Vr1) niedriger ist als die vorbestimmte zweite Schwellenspannung (Vr2);
wobei das Vergleichsmodul (27) beinhaltet:
einen ersten Komparator (271) mit einem nicht invertierenden Eingangsanschluss, welcher in Verwendung die vorbestimmte erste Schwellenspannung (Vr1) empfängt, einem invertierenden Eingangsanschluss, welcher mit dem Subtrahierer (26) gekoppelt ist, um die Differenzspannung (Vdif) davon zu empfangen, und einem Ausgangsanschluss;
einen zweiten Komparator (272) mit einem nicht invertierenden Eingangsanschluss, welcher mit dem Subtrahierer (26) gekoppelt ist, um die Differenzspannung (Vdif) davon zu empfangen, einem invertierenden Eingangsanschluss, welcher in Verwendung die vorbestimmte zweite Schwellenspannung (Vr2) empfängt, und einem Ausgangsanschluss; und
ein ODER-Gatter (273) mit einem ersten Eingangsanschluss, welcher mit dem Ausgangsanschluss des ersten Komparators (271) gekoppelt ist, einem zweiten Eingangsanschluss, welcher mit dem Ausgangsanschluss des zweiten Komparators (272) gekoppelt ist, und einem Ausgangsanschluss, welcher adaptiert ist, um die Bestimmungsausgabe (S2) bereitzustellen.

2. LED-Fehlererkennungsvorrichtung (2) nach Anspruch 1, **dadurch gekennzeichnet, dass** die erste Steuereingabe eine Vielzahl von Schaltsteuersignalen (Vy₁-Vy₄) und eine Vielzahl von Stromsteuersignalen (Vx₁-Vx₄) beinhaltet, und die Treiberschaltung (21) beinhaltet:
eine Vielzahl von Schaltern (22₁-22₄), welche jeweils einen ersten Anschluss, welcher in Verwendung eine Versorgungsspannung (Vdd) empfängt, einen zweiten Anschluss, welcher in Verwendung mit einer entsprechenden der Abtastlinien (11₁-11₄) gekoppelt ist, und einen Steueranschluss, welcher ein entsprechendes der Schaltsteuersignale (Vy₁-Vy₄) empfängt, aufweisen; und
eine Vielzahl von Stromquellen (23₁-23₄), welche jeweils adaptiert ist, um ein entsprechendes der Stromsteuersignale (Vx₁-Vx₄) zu empfangen, welches jeweils adaptiert ist, um ein entsprechendes Treiberstromsignal auf Basis des entsprechenden einen der Stromsteuersignale (Vx₁-Vx₄) zu erzeugen, und welches in Verwendung jeweils mit einer entsprechenden einen der Datenlinien (12₁-12₄) gekoppelt ist, um das Treiberstromsignal dazu bereitzustellen.

## Revendications

1. Dispositif (2) de détection de défaillance de diode électroluminescente, DEL, associé de manière fonctionnelle à un réseau de DEL (1), le réseau de DEL (1) comportant une pluralité de lignes de balayage (11₁ à 11₄), une pluralité de lignes de données (12₁ à 12₄) et une pluralité d'unités de DEL (13) qui sont agencées en une matrice ayant une pluralité de rangées et une pluralité de colonnes, chacune des unités de DEL (13) ayant une première borne et une seconde borne, et permettant une circulation de courant à travers celles-ci de la première borne de celle-ci à la seconde borne de celle-ci ; pour chacune des rangées des unités de DEL, les premières bornes des unités de DEL (13) étant couplées à une ligne respective parmi les lignes de balayage (11₁ à 11₄) ; pour chacune des colonnes des unités de DEL, les secondes bornes des unités de DEL (13) étant couplées à une ligne respective parmi les lignes de données (12₁ à 12₄) ; ledit dispositif (2) de détection de défaillance de DEL comprenant :
un circuit d'attaque (21) en utilisation couplé aux lignes de balayage (11₁ à 11₄) et aux lignes de données (12₁ à 12₄), adapté pour recevoir une première entrée de commande qui correspond à une sélection d'une unité parmi les unités de DEL (13), et adapté pour attaquer les unités de DEL (13) sur la base de la première entrée de commande d'une manière telle qu'un courant circule à travers ladite une unité parmi les unités de DEL (13) ; et **caractérisé par**
un circuit de détermination (24) en utilisation couplé aux lignes de données (12₁ à 12₄) pour recevoir une pluralité de premières tensions (Vd₁ à Vd₄) respectivement au niveau de celles-ci, et en outre adapté pour recevoir une seconde entrée de commande (S1) qui au moins correspond à une sélection d'une ligne parmi les lignes de données (12ₙ) qui est couplée à ladite une unité parmi les unités de DEL (13), ledit circuit de détermination (24) étant adapté pour générer, sur la base au moins des premières tensions (Vd₁ à Vd₄) et de la seconde entrée de commande (S1), une sortie de détermination (S2) qui indique si ladite une unité parmi les unités de DEL (13) est déterminée comme étant défaillante ; et
un circuit de commande (30) couplé audit circuit d'attaque (21) et audit circuit de détermination (24) ; pour ladite une unité parmi les unités de DEL (13), ledit circuit de commande (30) étant adapté pour générer la première entrée de commande pour une réception par ledit circuit d'attaque (21), adapté pour générer la seconde entrée de commande (S1) pour une réception par ledit circuit de détermination (24), adapté pour recevoir la sortie de détermination (S2) à partir dudit circuit de détermination (24), et adapté pour générer une sortie de détection sur la base de la sélection de ladite une unité parmi les unités de DEL (13) et de la sortie de détermination (S2) ;
ledit circuit de détermination (24) comportant
un multiplexeur (25) en utilisation couplé aux lignes de données (12₁ à 12₄) pour recevoir les premières tensions (Vd₁ à Vd₄) respectivement au niveau de celles-ci, en outre adapté pour recevoir la seconde entrée de commande (S1), et adapté pour délivrer en sortie, sur la base de la seconde entrée de commande (S1), une tension parmi les premières tensions (Vdₙ) au niveau de ladite une ligne parmi les lignes de données (12ₙ) qui est couplée à ladite une unité parmi les unités de DEL (13),
un soustracteur (26) couplé audit multiplexeur (25) pour recevoir ladite une tension parmi les premières tensions (Vdₙ) délivrée en sortie par celui-ci, en utilisation pour recevoir en outre une seconde tension prédéterminée (Vp), et adapté pour obtenir une différence entre ladite une tension parmi les premières tensions (Vdₙ) et la seconde tension (Vp) pour générer une tension de différence (Vdif), et
un module de comparaison (27) couplé audit soustracteur (26) pour recevoir la tension de différence (Vdif) à partir de celui-ci, en utilisation pour recevoir en outre une première tension seuil prédéterminée (Vr1) et une seconde tension seuil prédéterminée (Vr2), et adapté pour comparer la tension de différence (Vdif) avec les première et seconde tensions seuil prédéterminées (Vr1, Vr2) pour générer la sortie de détermination (S2) ;
la première tension seuil prédéterminée (Vr1) étant inférieure à la seconde tension seuil prédéterminée (Vr2) ;
ledit module de comparaison (27) comportant
un premier comparateur (271) ayant une borne d'entrée non inverseuse qui en utilisation reçoit la première tension seuil prédéterminée (Vr1), une borne d'entrée inverseuse qui est couplée audit soustracteur (26) pour recevoir la tension de différence (Vdif) à partir de celui-ci, et une borne de sortie ;
un second comparateur (272) ayant une borne d'entrée non inverseuse qui est couplée audit soustracteur (26) pour recevoir la tension de différence (Vdif) à partir de celui-ci, une borne d'entrée inverseuse qui en utilisation reçoit la seconde tension seuil prédéterminée (Vr2), et une borne de sortie ; et
une porte OU (273) ayant une première borne d'entrée qui est couplée à ladite borne de sortie dudit premier comparateur (271), une seconde borne d'entrée qui est couplée à ladite borne de sortie dudit second comparateur (272), et une borne de sortie qui est adaptée pour fournir la sortie de détermination (S2).

2. Dispositif (2) de détection de défaillance de DEL selon la revendication 1, **caractérisé en ce que** la première entrée de commande comporte une pluralité de signaux de commande de commutation (Vy₁ à Vy₄) et une pluralité de signaux de commande de courant (Vx₁ à Vx₄), et ledit circuit d'attaque (21) comporte :
une pluralité de commutateurs (22₁ à 22₄) ayant chacun une première borne qui en utilisation reçoit une tension d'alimentation (Vdd), une seconde borne qui en utilisation est couplée à une ligne respective parmi les lignes de balayage (11₁ à 11₄), et une borne de commande qui reçoit un signal respectif parmi les signaux de commande de commutation (Vy₁ à Vy₄) ; et
une pluralité de sources de courant (23₁ à 23₄), chacune desquelles est adaptée pour recevoir un signal respectif parmi les signaux de commande de courant (Vx₁ à Vx₄), chacune desquelles est adaptée pour générer un signal de courant d'attaque respectif sur la base du signal respectif parmi les signaux de commande de courant (Vx₁ à Vx₄), et chacune desquelles en utilisation est couplée à une ligne respective parmi les lignes de données (12₁ à 12₄) pour fournir le signal de courant d'attaque à celles-ci.
